# EUROPEAN PATENT SPECIFICATION

(11) **EP 2 630 076 B1**
(45) Date of publication and mention of the grant of the patent: **26.08.2015**
(21) Application number: 10858758.5
(22) Date of filing: 21.10.2010
(51) Int. Cl.: B82B 1/00, B82B 3/00

(54) **FORMATION OF CAPPED NANO-PILLARS**
BILDUNG VON GEKAPPTEN NANOSÄULEN
FORMATION DE NANOPILIERS COIFFÉS

(43) Date of publication of application: 28.08.2013
(73) Proprietor: Hewlett-Packard Development Company, L.P., Houston, TX 77070 (US)
(72) Inventor: MARDILOVICH, Peter, Corvallis Oregon 97330 (US); WEI, Qingqiao, Corvallis Oregon 97370 (US); FULLER, Anthony, M., Corvallis Oregon 97330 (US)
(74) Representative: Lawman, Matthew John Mitchell
(86) International application number: PCT/US2010/053533
(87) International publication number: WO 2012/054040

(56) References cited:
- EP-A2- 2 003 091
- WO-A1-2010/039871
- US-A1- 2009 034 122
- US-A1- 2010 108 519
- MOZALEV A ET AL: "Nucleation and growth of the nanostructured anodic oxides on tantalum and niobium under the porous alumina film", ELECTROCHIMICA ACTA, ELSEVIER SCIENCE PUBLISHERS, BARKING, GB, vol. 48, no. 20-22, 30 September 2003 (2003-09-30), pages 3155-3170, XP004447013, ISSN: 0013-4686, DOI: 10.1016/S0013-4686(03)00345-1
- NIELSCH K ET AL: "Uniform Nickel Deposition into Ordered Alumina Pores by Pulsed Electrodeposition", ADVANCED MATERIALS, WILEY - V C H VERLAG GMBH & CO. KGAA, DE, vol. 12, no. 8, 4 April 2000 (2000-04-04), pages 582-586, XP002548117, ISSN: 0935-9648, DOI: _

## Description

### BACKGROUND

The present disclosure relates generally to nano-structured surfaces, and more particularly, to the formation of capped nano-pillars on such surfaces. Such capped nano-pillars are suitable for use in a wide variety of applications, including applications for shock absorption, promoting adhesion, tuning surface wettability, and micro- or nano-fluidic filtration, among other applications.

Nano-scale surface structures may be formed using a template formed on the surface by an anodic oxidation process that involves immersing a workpiece in an acidic solution, and applying a voltage and/or current with the workpiece serving as an anode to cause oxidation of the workpiece surface so as to form pores (on a nanometer scale) in the workpiece surface. The porous surface structure then may be used as a template, pores in the surface being filled with a material to define nano-structures in the form of nano-pillars. Once the pores are filled, the template may be removed to expose one or more arrays of nano-pillars formed on and supported by the workpiece surface.

Fabrication processes for forming the nano-structures often dictate, at least in part, the geometry and/or chemistry of individual nano-pillars, as well as the population density of arrays of the nano-pillars in the structure. In some cases, non-uniformity with regard to the geometry, chemistry and/or population density of the nano-pillars may render the nano-structureed surface unsuitable for some applications. Furthermore, limitations of the aforementioned fabrication process make it difficult to fabricate nano-structures that deviate from simple columnar shape.

"Nucleation and growth of the nanostructured anodic oxides on tantalum and niobium under the porous alumina film" by Mozalev et al discloses anodic oxidation of aluminium deposited on tantalum and aluminium deposited on niobium to form nanoscale oxide "hillocks" and "goblets".

US 2009/034122 discloses a process for producing a structure in which an underlying metal layer and an anode-oxidization layer a placed on a substrate, the anode-oxidization layer is anodized to form a porous film, and an oxide of the underlying metal layer is grown from the bottoms of the pores of the porous film.

"Uniform Nickel Deposition into Ordered Alumina Pored by Pulsed Electrodeposition" by Nielsch et al discloses a process for fabricating nanoscale structures in which an alumina pore structure is formed by anodization, nickel is deposited into the pores by electrodeposition, and in which monodisperse nanowires are formed by dissolving the porous alumina following electrodeposition.

### BRIEF DESCRIPTION OF THE DRAWINGS

Features and advantages of embodiments of the present disclosure will become apparent by reference to the following detailed description and drawings, in which like reference numerals correspond to similar, though perhaps not identical, components. For the sake of brevity, reference numerals or features having a previously described function may or may not be described in connection with other drawings in which they appear.
Fig. 1 is a simplified perspective view of a schematic depiction of an article including an array of capped nano-pillars formed in accordance with an embodiment of the present invention.
Fig. 2 is a cross-sectional view of the article shown in Fig. 1, taken generally along line 2-2 of Fig. 1.
Figs. 3A through 3E schematically depict a method of fabricating an article having capped nano-pillars in accordance with an embodiment of the present invention.
Figs. 4A through 4C schematically depict example capped nano-pillars formed in accordance with embodiments of the present invention.
Fig. 5 is a flowchart showing a method of forming capped nano-pillars on a substrate in accordance with an embodiment of the present invention.

### DETAILED DESCRIPTION

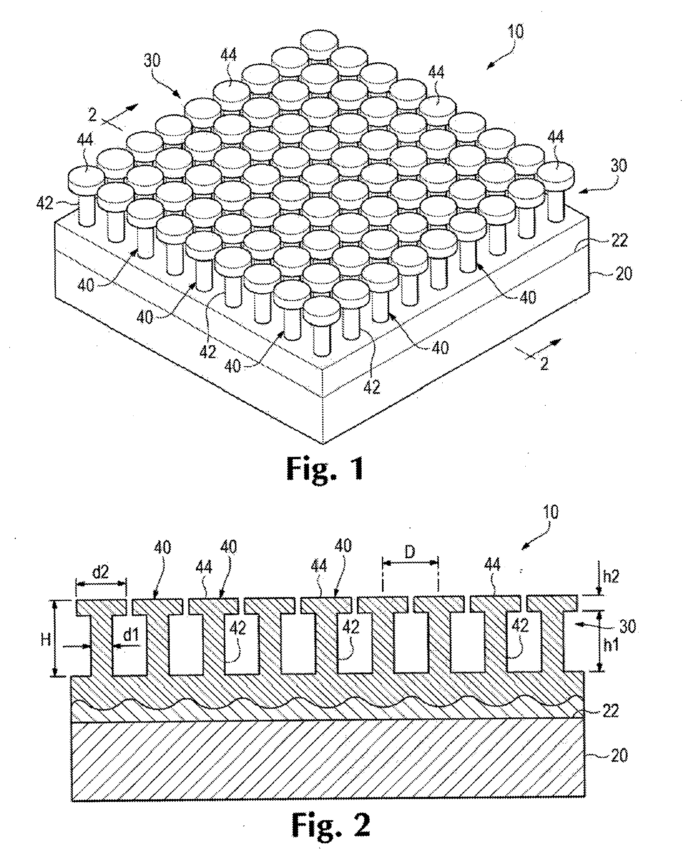

Referring initially to Fig. 1, an article 10 is shown, the depicted article including a substrate 20 having a surface 22 with a nano-structure array 30 formed thereon. Nano-structure array 30 includes a plurality of nano-pillars 40, each having a stem portion 42 and a cap portion 44.

The methods disclosed herein may be used to control various properties of the nano-pillars and nano-structure array. For example, placement of nano-pillars in the nano-structure array may be selectively controlled via the methods disclosed herein. Similarly, the size of gap formed between adjacent nano-pillars may be selectively controlled, and the geometry and/or dimensions of the nano-pillars (such as their height, diameter, shape, etc.) may be controlled.

In one example, the nano-pillars 40 are elongate structures that extend orthogonal to the substrate. The geometry of the nano-pillars may be controlled so that the nano-pillars have substantially uniform shape. Similarly, as shown in Fig. 2, the nano-pillars may be substantially uniform in height (H), and the pitch of the nano-pillars (the center-to-center distance between nano-pillars (D)) may be substantially uniform. Nano-pillars 40 thus may be substantially uniformly spaced across at least a portion of the substrate surface, providing a substantially uniform nano-structured surface. Dimensions of nano-pillars generally will vary by less than 10% to 20% (for nanometer scale dimensions), and in some examples, may vary by as little as 1% or 2%.

Referring now to Figs 1 and 2, it will be appreciated that nano-pillars 40 each include an elongate stem section 42 extending from the substrate and an elongate cap portion 44 extending from the stem portion. The example stem portions take the form of cylindrical columns, each generally characterized as having a stem diameter (d1) and a stem height (h1). As indicated, stem portions 42 have substantially uniform stem heights (h1), and have substantially uniform stem thicknesses (represented by stem diameter (d1)) along such stem heights. The example cap portions 44 similarly take the form of cylindrical columns, each generally characterized as having a cap diameter (d2) and a cap height (h2). Cap portions 44 also have substantially uniform cap heights (h2), and substantially uniform thicknesses (represented by cap diameter (d2)) along such cap heights.

In the depicted example, the stem diameters (d1) are less than the cap diameters (d2), giving the depicted nano-pillars a generally "T" shape. It also will be noted that the example nano-pillars have stem heights (h1) that are greater than cap heights (h2), enhancing the T-shaped appearance of the nano-pillars. Such T-shaped appearance may enhance adhesive properties of the substrate. However, as will be described further below, the nano-pillars can have other geometries, which may be determined at least in part by parameters of the fabrication process (e.g., anodization voltage, current density, nature of electrolyte, etc.). For example, it is possible to control height, diameter, shape, and spacing between nano-pillars. It thus will be appreciated that the fabrication process may be manipulated to tune nano-pillar geometry and spacing to accommodate a variety of particular uses of article 10 and/or substrate 20.

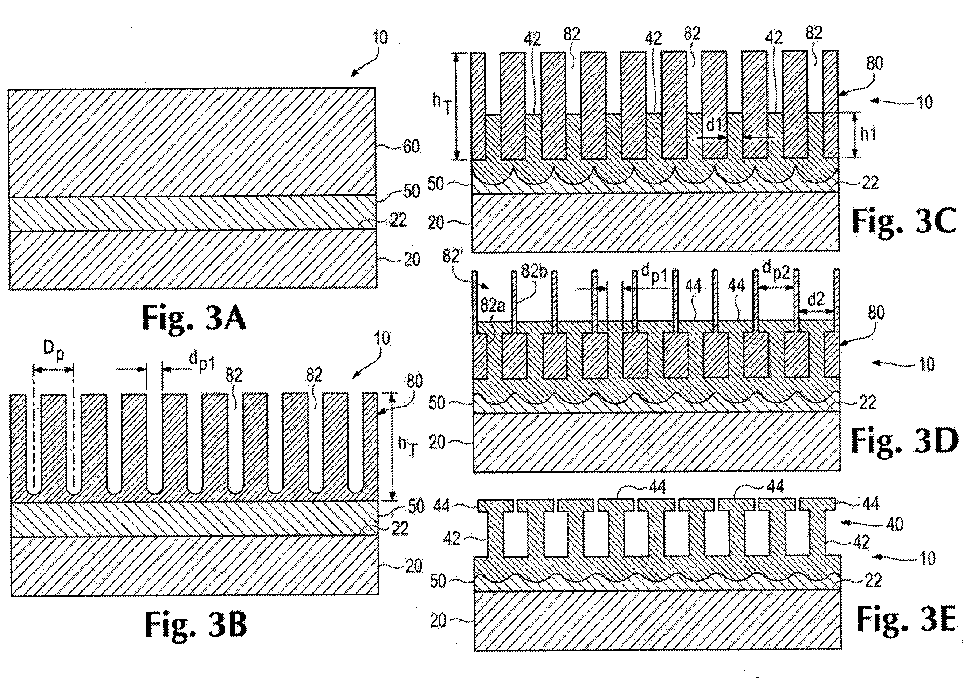

Figs. 3A-3E depict an article 10 through various stages of fabrication. As shown, a substrate 20 thus may be adapted, through the present method, to include a nano-structured surface that includes an array of capped nano-pillars. Although a particular nano-pillar geometry is shown, it will be understood that the fabrication process parameters may be altered to achieve particular nano-pillar dimensions.

Referring initially to Fig. 3A, fabrication begins with a substrate 20 having a surface 22. Substrate 20 may be selected based, at least in part, on the application for which article 10 will ultimately be used. If, for example, article 10 is to be used for semiconductor applications, substrate 20 may be formed from suitable support structures for semiconductors, such as a substantially planar silicon wafer.

Substrate 20 similarly may be formed from other materials, e.g., glass, quartz, alumina, stainless steel, plastic, and/or the like, and may take any of a variety of forms, including a multilayer structure and/or a structure with a non-planar surface. In the present example, a substantially planar substrate is shown (meaning that the surface is flat but may contain some irregularities).

As shown, a first oxidizable material is deposited on substrate 20 to form a layer of first oxidizable material 50. The first oxidizable material layer 50 may be formed using any suitable deposition technique known in the art. Some non-limiting examples of suitable deposition techniques include physical vapor deposition (PVD) (such as sputtering, thermal evaporation and pulsed laser deposition), atomic layer deposition (ALD), or, in some instances, chemical vapor deposition (CVD).

In some examples, the first oxidizable material layer 50 may be formed of a metal or metal alloy that forms a dense metal oxide after electrochemical oxidation. Suitable oxidizable materials include oxidizable refractory metals such as tantalum (Ta), niobium (Nb), titanium (Ti), tungsten (W), or their alloys. Such oxidizable materials all can be electrochemically and/or thermally oxidized, and all have expansion coefficients (the ratio between thickness of the grown oxide and thickness of the consumed material) that are greater than 1.

In the present example, first oxidizable material layer 50 is formed of tantalum (Ta), which has been found suitable for use in the method described herein. The example first oxidizable material layer also is referred to herein as the "Ta layer". The Ta layer may have any suitable thickness that will produce (during electrochemical oxidation) enough oxide to form the nano-structures (which will be described in further detail below). In some examples, the thickness of the Ta layer may be approximately 100 to 1000 nanometers.

Referring still to Fig. 3A, it will be noted that a second oxidizable material is deposited on the Ta layer to form a layer of second oxidizable material 60. The second oxidizable material layer may have a thickness selected to produce a porous oxide (as described below), which corresponds to the desired nano-structures to be formed. The second oxidizable material may be aluminum (Al), or may be an aluminum alloy such as an alloy having aluminum as the main component. Second oxidizable material layer 60 also is referred to herein as the "Al layer". The Al layer may have any suitable thickness that will produce (during electrochemical oxidation) enough oxide to form a template sufficient to produce the intended nano-structures. In some examples, the thickness of the Al layer may be approximately 100 to 1000 nanometers.

Deposition of the second oxidizable material layer on the first oxidizable material layer may be accomplished using any suitable deposition technique known in the art. Some non-limiting examples of suitable deposition techniques include physical vapor deposition (PVD) (such as sputtering, thermal evaporation and pulsed laser deposition.

As shown generally in Fig. 3B, the multi-layer structure of Fig. 3A may be further processed to form a nano-structure template 80 on substrate 20. The nano-structure template defines a plurality of nano-pores 82, each having a first width (indicated as nano-pore diameter (dₚ₁), in the present example). Such nano-pores are suitable for use in forming nano-structures on the substrate, as will be described herein.

In some examples, further processing includes a first anodization process whereby second oxidizable material layer 60 (Fig. 3A) is anodized to define a plurality of substantially uniform, cylindrical nano-pores 82. Such nano-pores may be formed by completely anodizing the second oxidizable material layer 60 (e.g., the Al layer) so as to produce a nano-structure template 80 in the form of a layer of porous oxide (e.g., anodic porous alumina, Al₂O₃) with nano-pores 82. Complete anodization refers to the oxidation sufficiently through the thickness of the layer being anodized to allow anodization of underlying first oxidizable material layer 50, as will be described below.

Anodization (i.e., electrochemical oxidation) is a process of forming an oxide layer on a material by making the material the anode in an electrolytic cell and passing an electric current through the cell. For anodization of aluminum, as in the present example, applied voltage may be kept constant at voltage within a range of about 10 V to 200 V. In some examples, the first anodization process may occur at a voltage of about 30 V

As indicated generally above, it is possible to adjust geometry by adjusting parameters of the fabrication process. For example, geometry of the nano-structure template 80 may be adjusted by varying one or more of anodization voltage, current density and electrolyte. Such adjustments to the first anodization process may alter nano-pore pitch (Dₚ) and/or nans-pore diameter (dpi), which characteristics are illustrated in Fig. 3B. For example, nano-pore pitch may be related to anodization voltage, where nanometer pitch (Dₚ) is 2.8 nanometres per volt of anodization voltage. Nano-pore pitch (Dₚ) generally may be adjusted within a range of from about 30 nanometers to about 500 nanometers. Nano-pore diameter (dₚ₁) generally may be adjusted within a range of from about 10 nanometers to about 350 nanometers.

Anodization can be performed at constant current (galvanostatic regime), at constant voltage (potentiostatic regime) or at some combination of these regimes. Nano-pore diameter (dₚ₁) is proportional to anodization voltage. Accordingly, a potentiostatic regime may be employed to produce a porous substrate with nano-pores having substantially uniform nano-pore diameter (dₚ₁). Substantially uniform nano-pores 82, in turn, will yield substantially uniform nano-pillars 40, as will be described below.

The first anodization process may be carried out by exposing Al layer 60 to an electrolytic bath containing an oxidizing acid such as sulfuric acid (H₂SO₄), phosphoric acid (H₃PO₄) oxalic acid (C₂H₂O₄) and/or chromic acid (H₂CrO₄). The electrolyte may be present, for example, in a water-based solution. The voltage applied during the first anodization process may be selected based on the electrolyte composition. For example, the voltage may range from 5-25V for an electrolyte based on sulfuric acid, 10-80V for an electrolyte based on oxalic acid, and 50-150V for an electrolyte based on phosphoric acid. The particular voltage used will depend on the desired pore diameter (and the suitable of such voltage for the electrolyte).

Nano-pore diameter (dₚ₁) also is related to the nature of the electrolyte used. Accordingly, an electrolyte may be selected to achieve a particular desired nano-pore diameters (dₚ₁). As non-limiting examples, nano-pores 82 of the following sizes may be obtained using the following electrolyte: nano-pore diameters (dₚ₁) of about 20 nanometers may be obtained using H₂SO₄ (in a water-based solution) as the electrolyte; nano-pores diameters (dₚ₁) of about 40 nanometers may be obtained using C₂H₂O₄ (in a water-based solution) as the electrolyte; and nano-pores diameters (dₚ₁) of about 120 nanometers may be obtained using H₃PO₄ (in a water-based solution) as the electrolyte.

In one example, nano-structure template 80 is formed by anodization of the second oxidizable material layer 60 in a 4% solution of oxalic acid (C₂H₂O₄), at a voltage of 30 Volts until substantially the entire Al layer is consumed. For a suitably thick Al layer, the resulting nano-structure template 80 will define nano-pores 82 that are approximately 30 nanometers wide, and that will allow oxidation of underlying first oxidizable material layer 50. The nano-structure template should have a template height (h_{T}) sufficient to allow complete growth of a nano-pillars 40 (including both stem portions 42 and cap portions 44) within the nano-pores, as described below.

After the first anodization process, the nano-pore diameter (dₚ₁) may be further tuned to a target nano-pore diameter by anisotropic etching, or other suitable process. Anisotropic etching may be performed using diluted phosphoric acid (5 vol.%). The time for etching may vary, depending, at least in part, upon the desirable average diameter for the final pores. The temperature for etching may also depend upon the process, the etching rate, and the etchant used.

In some examples, prior to performing the first anodization process, the first oxidizable material layer may be patterned to precisely define locations of nano-pores 82 in the resulting nano-structure template 80. Patterning may be accomplished via any suitable technique. The patterned layer (not shown) is then anodized, for example, by employing the patterned layer as the anode of an electrolytic cell. A suitable amount of voltage and current is then applied to the electrolytic cell for an amount of time to completely anodize the patterned layer in accordance with the first anodization process described above. This can result in substantially uniformly spaced nano-structures where the variance in spacing between nano-structures differs by less than 1 % (for nanometer scale dimensions).

Referring now to Fig. 3C, nano-pores 82 may be partially filled to define nano-pillar stem portions 42. Nano-pillar stem portions may be formed via a second anodization process selected to partially anodize the underlying first oxidizable material layer 50 (e.g., the Ta layer). Such second anodization process will grow an oxide from the first oxidizable material, the oxide forming in the nano-pores 82 of the nano-structure template 80 from the bottom up. Where the first oxidizable material layer 50 is formed of a metal such as tantalum (Ta), the resulting oxide may take the form of a dense oxide such as anodic tantalum pentoxide (Ta₂O₅).

The second anodization process may be accomplished, for example, using a process similar to the first anodization process described above. More specifically, the first oxidizable material layer 50 is anodized by employing the first oxidizable material layer as the anode of an electrolytic cell to achieve a desired oxidation of the first oxidizable material.

For oxidation of tantalum, non-limiting examples of electrolyte may include solutions containing citric acid (C₆H₈O₇), oxalic acid (C₂H₂O₄), boric acid (H₃BO₃), ammonium pentaborate ((NH₄)₂B₁₀O₁₆ x 8H₂O), and/or ammonium tartrate (H₄NO₂CCH(OH)CH(OH)CO₂NH₄). It is to be understood that this type of anodization forms a dense oxide, where both the interface between the remaining first oxidizable material and the formed oxide, and the interface between the formed oxide and the electrolyte are planarized.

During anodization of the first oxidizable material layer 50 (in this example, a tantalum layer), the formed oxide (in this example, tantalum pentoxide (Ta₂O₅)) grows through the individual nano-pores 82 defined in nano-structure template 80 to form a nano-pillar stem portion 42 in each nano-pore. The orientation of nano-pillar stem portions 42 is generally controlled by the orientation of the nano-pores 82. In the present example, the nano-pillar stem portions 42 are substantially orthogonal to the surface 22 of substrate 20.

The expansion coefficient of a material to be oxidized is defined as the ratio of oxide volume to consumed material volume. The expansion coefficient for oxidation of tantalum (Ta) is approximately 2.3. Accordingly, in the present example, due to the significant expansion of tantalum pentoxide (Ta₂O₅), and the fact that the resulting oxide (Ta₂O₅) is dense, the nano-pores 82 are filled from the bottom up. It will be understood that although the first oxidizable material is tantalum (Ta) in the present example, other materials with an expansion coefficient greater than 1 would similarly allow the oxidizable material to squeeze into the nano-pores 82 of template 80.

As indicated, the grown oxide will partially fill nano-pores 82 of nano-structure template 80 to define nano-pillar stem portions 42. The geometries of the nano-pillar stem portions 42 will substantially conform to the geometries of corresponding nano-pores 82, within which the nano-pillar stem portions are growing. Nano-pillar stem portions 42 thus may take the form of substantially uniform cylindrical columns, substantially uniformly spaced across surface 22 of substrate 20.

In the present example, each nano-pillar stem portion has a substantially uniform stem thickness (indicated as stem diameter (d1)) that corresponds to the nano-pore diameter (dₚ₁). Nano-pillar stem portions 42 are grown to a stem height (h1) that is less than template height (hᵣ) so as to allow subsequent growth of nano-pillar cap portions 44. As shown, some residual first oxidizable material will remain beneath the grown oxide after the second anodization process (Fig. 3C). This residual first oxidizable material may subsequently be used to grow nano-pillar cap portions 44.

The geometry and/or dimensions of the nano-pillar stem portions 42 may further be controlled by adjusting one or more parameters of the anodization process. For example, the stem height (h1) will depend on the anodization voltage applied to the first oxidizable material layer 50 during its anodization. In some examples, nano-pillar stem portions are formed by anodizing the first oxidizable material at a first voltage corresponding to a target nano-pillar stem portion height.

In one example, nano-pillar stem portions having a stem height (h1) of 90 nanometers (at a stem diameter of approximately 30 nanometers) may be formed by anodization of Ta layer 50 in a 0.1% solution of citric acid (C₆H₈O₇), at a current density of 2 mA/cm² until voltage reaches 55 Volts, and for 5 minutes more at 55V. It will be appreciated that stem height (h1) may be tuned to a target stem height by selecting a corresponding anodization voltage. For example, nano-pillar stem portions having a stem height of 155 nanometers may be formed by anodization of Ta layer 50 in a 0.1% solution of citric acid (C₆H₈O₇) at a current density of 2 mA/cm² until voltage reaches 100 Volts, and for 5 minutes more at 100V.

As indicated in Fig. 3D, once the nano-pillar stem portions are grown to the target stem height (h1), the nano-pores 82 may be re-shaped to define re-shaped nano-pores 82' with separate stem-forming sections 82a and cap-forming sections 82b. In the depicted example, the nano-pores remain substantially unchanged in stem-forming sections 82a, but are broadened in cap-forming sections 82b, thereby providing for subsequent formation of nano-pillar cap portions 44 that are wider than previously formed nano-pillar stem portions 42. As indicated, the re-shaped nano-pores 82' have a first width (indicated as original nano-pore diameter (dₚ₁)) in stem-forming sections 82a, and a second, different width (indicated as modified nano-pore diameter (dₚ₂) in cap-forming sections 82b. The modified nano-pore diameter (dₚ₂) is greater than the original nano-pore diameter (dₚ₁).

In some examples, nano-pores 82 are re-shaped by broadening unfilled sections of the nano-pores 82 (the sections of the nano-pores above the formed stem portions 42). Such broadening may be achieved by selective etching of the nano-structure template 80. Selective etching may be accomplished by employing an etchant solution configured to etch the exposed areas of porous oxide forming the nano-structure template 80 (e.g., anodic porous alumina, Al₂O₃) at a rate that is substantially higher than the etch rate for the oxide of the first oxidizable material (e.g., anodic tantalum pentoxide (Ta₂O₅)).

In one example, porous alumina nano-structure template 80 (with nano-pores that are approximately 30 nanometers wide) is etched in a 5% solution of phosphoric acid (H₃PO₄) at a temperature of 30 °C. for approximately 15 minutes to broaden the nano-pores to a modified nano-pore diameter (dₚ₂) of approximately 60 nanometers. In another example, the porous alumina nano-structure template 80 is etched in a 5% solution of phosphoric acid (H₃PO₄) at a temperature of 30 °C for approximately 30 minutes to broaden the nano-pores to a modified nano-pore diameter (dₚ₂) of approximately 80 nanometers. It thus will be appreciated that the width of the broadened sections (cap-forming sections 82b) may be tuned to a target width by selecting an etch duration corresponding to the target width.

Referring now to Fig. 3D, it will be seen that the cap-forming sections 82b of re-shaped nano-pores 82' may be at least partially filled to define nano-pillar cap portions 44 contiguous with nano-pillar stem portions 42. In some examples, the nano-pillar cap portions may be formed via a third anodization process selected to anodize the residual first oxidizable material (e.g., the remaining Ta layer) to continue the process of growing oxide into the (now) re-shaped nano-pores 82'.

As described generally above, the third anodization process will grow oxide into the re-shaped nano-pores 82' from the bottom up. The resulting oxide thus will cause previously formed oxide to grow from the stem-forming sections 82a into the cap-forming sections 82b. The third anodization process may be substantially the same as the second anodization process, but at an anodization voltage corresponding to a target nano-pillar cap portion height.

More specifically, the first oxidizable material layer 50 is again anodized by employing the first oxidizable material layer as the anode of an electrolytic cell, and applying a suitable amount of an anodization voltage and current to the first oxidizable material layer to achieve a desired oxidation. As described above, non-limiting examples of electrolyte for oxidation of tantalum (Ta) include solutions containing citric acid (C₆H₈O₇), oxalic acid (C₂H₂O₄), boric acid (H₃BO₃), ammonium pentaborate ((NH₄)₂B₁₀O₁₆ x 8H₂O), and/or ammonium tartrate (H₄NO₂CCH(OH)CH(OH)CO₂NH₄). The electrolyte may be present, for example, in a water-based solution.

Again, anodization of the Ta layer will be understood to form a dense oxide (in this example, tantalum pentoxide (Ta₂O₅)), where both the interface between the remaining first oxidizable material and the formed oxide, and the interface between the dense oxide and the electrolyte are planarized.

Because orientation of nano-pillars is generally controlled by the orientation of the re-shaped nano-pores 82', where the re-shaped nano-pores are orthogonal to surface 22 of substrate 20, the fully grown nano-pillar stem portions 42 and nano-pillar cap portions 44 are substantially orthogonal to surface 22 of substrate 20 (shown in Fig. 3E). It also will be appreciated that the cap portions 44 take the form of substantially uniform cylindrical columns, conforming to the shape of cap-forming sections 82b.

In the present example, each nano-pillar cap portion 44 has a substantially uniform cap thickness (indicated as cap diameter (d2)) that corresponds to the nano-pore diameter (dₚ₂). Nano-pillar cap portions 42 are grown to a cap height (h2), providing nano-pillars of overall height (h). As shown, some residual first oxidizable material will remain beneath the grown oxide after the second anodization process (Fig. 3C). This residual first oxidizable material may subsequently be used to grow nano-pillar cap portions 44.

Nano-pillar cap portions having a cap height (h2) of approximately 100 nanometers (at a cap diameter (d₂) of approximately 60 nanometers) may be formed by anodization of Ta layer 50 in a 0.1% solution of citric acid (C₆H₈O₇), at a current density of 2 mA/cm² until voltage reaches 200V, and for 5 minutes more at 200V. Cap height (h2) may be tuned to a different target cap height by selecting a different final anodization voltage.

In Fig. 3E, the nano-structure template 80 is removed to expose the fully formed nano-structures array 30 with capped nano-pillars 40. The nano-structure template 80 may be removed using a second selective etching process that will remove the nano-structure template 80 without deleteriously affecting the nano-pillars 40, or other features of article 10. In one example, the selective etching may be performed using a selective etchant containing H₃PO₄ (92g), CrO₃ (32g) and H₂O (200g), at approximately 95°C. It has been found that the example tantalum pentoxide (Ta₂O₅) nano-pillars 40 can withstand this particular etching process for more than one hour, while the example anodic porous alumina (Al₂O₃) nano-structure template 80 is etched away at a rate of about 1 micron per minute. Other selective etchants are also contemplated, dependent on the particular characteristics of the nano-structures.

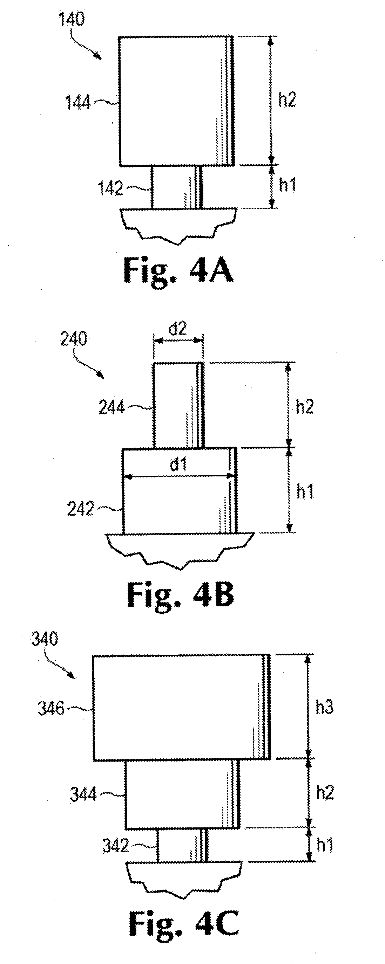

Although nano-structures having a particular T-shaped configuration are shown in Figs. 1 and 2, and formation of such nano-structures is demonstrated in Figs. 3A-3E, it will be appreciated that the forgoing principles may be applied to achieve nano-pillars of differing shapes and sizes. Figs. 4A-4C depict non-limiting examples of nano-pillars that may be achieved in accordance with the foregoing principles.

Figs. 4A shows an example nano-pillar 140 including a stem portion 142 having a stem height (h1) and a cap portion 144 having a cap height (h2), where h1 < h2. Nano-pillar 140 may be formed by the method described above in connection with formation of nano-pillars 40 (illustrated in Figs. 3A-3E).

Fig. 4B shows an example nano-pillar 240 including a stem portion 242 having a stem diameter (d1) and a cap portion 244 having a cap diameter (d2), where d1>d2. This may be accomplished, for example, in accordance with the method described above in connection with formation of nano-pillars 40. However, after forming the nano-pillar stem portions 242, the nano-pores of the nano-structure template are re-shaped to narrow the nano-pores, thereby providing for subsequent formation of nano-pillar cap portions 244 that are narrower than previously formed nano-pillar stem portions. In Fig. 4B, stem height (h1) and cap height (h2) are substantially equal, but other configurations are contemplated as well.

Fig. 4C shows an example nano-pillar 340 including a stem portion 342 having a stem height (h1), a first cap portion 344 having a stem height (h2), and a second cap portion 346 having a stem height (h3), where h1 < h2 < h3. Nano-pillar 340 may be formed by the method described above in connection with formation of nano-pillars 40 (illustrated in Figs. 3A-3E), but where the re-shaped nano-pore sections are re-shaped a second time after partial filling of the re-shaped nano-pore sections, and the further re-shaped sections of the nano-pores are at least partially filled before removing the nano-structure template.

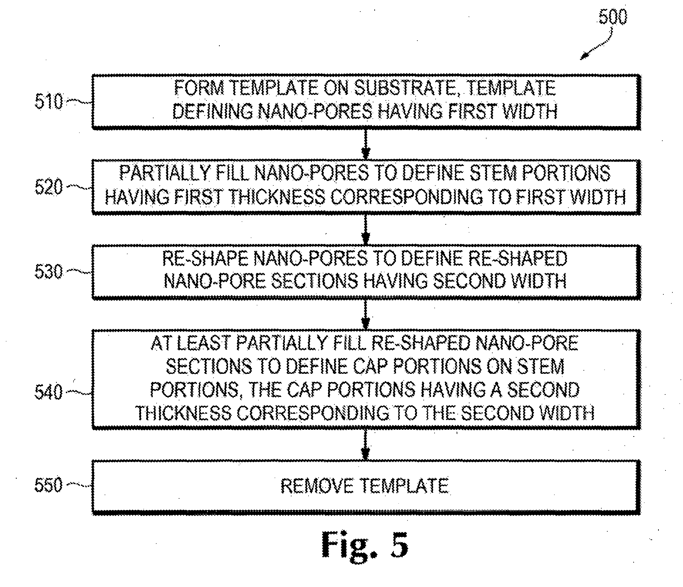

Fig. 5 shows a high-level flowchart 500 of a method of forming capped nano-pillars on a substrate, as described herein. The method generally includes: 1) providing a template on the substrate, the template defining nano-pores formed therein; 2) partially filling the nano-pores to form stem portions on the substrate; 3) re-shaping the nano-pores; 4) at least partially filling the re-shaped sections of the nano-pores to form cap portions on the stem portions; and 5) removing the template.

More particularly, at 510, a template is formed on the substrate. the template defining nano-pores having a first width. The template may be formed by anodizing a layer of oxidizable material on the substrate. At 520, the nano-pores are partially filled to define nano-pillar stem portions having a first thickness corresponding to the first witdth of the nano-pores. The nano-pillar stem portions may be formed by anodizing a layer of another oxidizable material disposed on the substrate, beneath the template, to grow an oxide into the nano-pores of the template.

At 530, the nano-pores are re-shaped to define re-shaped nano-pore sections having a second width different than the first width. Re-shaping the nano-pores may include selective etching of nano-pores sections that do not include nano-pillar stem portions. At 540, the re-shaped nano-pores are at least partially filled to define nano-pillar cap portions on the stem portions, the cap portions having a second thickness corresponding to the second width of the re-shaped nano-pore sections. The nano-pillar cap portions may be formed by further anodizing the layer of another oxidizable material disposed beneath the template, to grow oxide into the re-shaped nano-pore sections.

At 550, the template is removed. Removal of the template will reveal fully formed integral nano-pillars including stem portions and cap portions.

In some examples, the method of forming capped nano-pillars include: depositing a first oxidizable material onto the substrate; depositing a second oxidizable material onto the first oxidizable material; anodizing the second oxidizable material to form a porous oxide having nano-pores that extend through the porous oxide to expose portions of the first oxidizable material; anodizing the first oxidizable material so as to partially fill the nano-pores in the porous oxide with an oxide of the first oxidizable material; broadening unfilled sections of the nano-pores by selective etching; further anodizing the first oxidizable material so as to at least partially fill broadened sections of the nano-pores with the oxide of the first oxidizable material; and further removing porous oxide by selective etching, thereby yielding an array of capped nano-pillars on the substrate.

Anodizing the first oxidizable material may include anodizing the first oxidizable material at a first voltage corresponding to a target nano-pillar stem portion height. Similarly, further anodizing the first oxidizable material may include further anodizing the first oxidizable material at a second voltage corresponding to a target nano-pillar cap portion height. Broadening unfilled sections of the nano-pores may include etching of the substrate in an etchant solution configured to etch the porous oxide at a substantially higher etch rate than the oxide of the first oxidizable material.

Although the present invention has been described with reference to certain representative examples, various modifications may be made to these representative examples without departing from the scope of the appended claims.

## Claims

1. A method of forming capped nano-pillars (40) on a substrate (20), the method comprising:
forming a template (80) on the substrate, the template (80) defining nano-pores (82) having a first width;
partially filling the nano-pores (82) to define nano-pillar stem portions (42) of a first thickness corresponding to the first width;
re-shaping the nano-pores (82) to define re-shaped nano-pore sections (82') having a second width different than the first width;
at least partially filling the re-shaped nano-pore sections (82') to define nano-pillar cap portions (44) of a second thickness corresponding to the second width; and
removing the template (80).

2. The method of claim 1, wherein partially filling the nano-pores (82) includes:
forming a layer of a first oxidizable material (50); and
anodizing the layer of first oxidizable material (50) to grow oxide from the first oxidizable material (50) into the nano-pores (82).

3. The method of claim 2, wherein re-shaping the nano-pores (82) includes selectively etching the nano-pores (82) to broaden unfilled regions of the nano-pores (82).

4. The method of claim 3, wherein at least partially filling the re-shaped nano-pore sections (82') includes further anodizing the first oxidizable material (50) to grow oxide into the re-shaped sections (82').

5. The method of claim 1, wherein forming a template includes:
forming a layer of a second oxidizable material (60); and
anodizing the layer of second oxidizable material (60) to define the nano-pores (82).

6. The method of claim 5, comprising:
anodizing the layer of second oxidizable material (60) to form a porous oxide having nano-pores (82) that extend through the porous oxide to expose portions of the first oxidizable material (50).

7. The method of claim 6, wherein anodizing the first oxidizable material (50) comprises anodizing the first oxidizable material (50) with a first voltage corresponding to a target nano-pillar stem portion height (h1).

8. The method of claim 6, wherein further anodizing the first oxidizable material (50) comprises anodizing the first oxidizable material (50) with a second voltage corresponding to a target nano-pillar cap portion height (h2).

9. The method of claim 6, wherein broadening unfilled sections of the nano-pores (82) comprises etching of the substrate (20) in an etchant solution configured to etch the porous oxide at a substantially higher etch rate than the oxide of the first oxidizable material (50).

## Patentansprüche

1. Verfahren zum Bilden gekappter Nanosäulen (40) auf einem Substrat (20), wobei das Verfahren Folgendes umfasst:
Bilden einer Matrize (80) auf dem Substrat, wobei die Matrize (80) Nanoporen (82) mit einer ersten Breite definiert;
teilweises Füllen der Nanoporen (82), um Nanosäulenschaftteile (42) einer ersten Dicke zu definieren, die der ersten Breite entspricht;
Umformen der Nanoporen (82), um umgeformte Nanoporenabschnitte (82') mit einer zweiten Breite zu definieren, die unterschiedlich von der ersten Breite ist;
wenigstens teilweises Füllen der umgeformten Nanoporenabschnitte (82'), um Nanosäulenkappenteile (44) einer zweiten Dicke zu definieren, die der zweiten Breite entspricht; und
Entfernen der Matrize (80).

2. Verfahren nach Anspruch 1, wobei das teilweise Füllen der Nanoporen (82) Folgendes beinhaltet:
Bilden einer Schicht eines ersten oxidierbaren Materials (50); und
Anodisieren der Schicht des ersten oxidierbaren Materials (50), um Oxid von dem ersten oxidierbaren Material (50) in die Nanoporen (82) wachsen zu lassen.

3. Verfahren nach Anspruch 2, wobei das Umformen der Nanoporen (82) das selektive Ätzen der Nanoporen (82) umfasst, um nicht gefüllte Bereiche der Nanoporen (82) zu verbreitern.

4. Verfahren nach Anspruch 3, wobei das wenigstens teilweise Füllen der umgeformten Nanoporenabschnitte (82') das weitere Anodisieren des ersten oxidierbaren Materials (50) umfasst, um Oxid in die umgeformten Abschnitte (82') wachsen zu lassen.

5. Verfahren nach Anspruch 1, wobei das Bilden einer Matrize Folgendes beinhaltet:
Bilden einer Schicht eines zweiten oxidierbaren Materials (60); und
Anodisieren der Schicht des zweiten oxidierbaren Materials (60), um die Nanoporen (82) zu definieren.

6. Verfahren nach Anspruch 5, umfassend:
Anodisieren der Schicht des zweiten oxidierbaren Materials (60), um ein poröses Oxid mit Nanoporen (82) zu bilden, die sich durch das poröse Oxid erstrecken, um Teile des ersten oxidierbaren Materials (50) freizulegen.

7. Verfahren nach Anspruch 6, wobei das Anodisieren des ersten oxidierbaren Materials (50) das Anodisieren des ersten oxidierbaren Materials (50) mit einer ersten Spannung umfasst, die einer Sollhöhe (h1) des Nanosäulenschaftteils entspricht.

8. Verfahren nach Anspruch 6, wobei das weitere Anodisieren des ersten oxidierbaren Materials (50) das Anodisieren des ersten oxidierbaren Materials (50) mit einer zweiten Spannung umfasst, die einer Sollhöhe (h2) des Nanosäulenkappenteils entspricht.

9. Verfahren nach Anspruch 6, wobei das Verbreitern nicht gefüllter Abschnitte der Nanoporen (82) das Ätzen des Substrats (20) in einer Ätzlösung umfasst, die dazu konfiguriert ist, das poröse Oxid mit einer wesentlich höheren Ätzrate als das Oxid des ersten oxidierbaren Materials (50) zu ätzen.

## Revendications

1. Procédé pour la formation de nano-piliers coiffés (40) sur un substrat (20), le procédé comprenant :
la formation d'une matrice (80) sur le substrat, la matrice (80) définissant des nano-pores (82) présentant une première largeur ;
le remplissage partiel des nano-pores (82) pour définir des portions de tige de nano-pilier (42) d'une première épaisseur correspondant à la première largeur ;
le remodelage des nano-pores (82) pour définir des sections de nano-pore remodelées (82') présentant une deuxième largeur différente de la première largeur ;
le remplissage au moins partiel des sections de nano-pore remodelées (82') pour définir des portions de coiffe de nano-pilier (44) d'une deuxième épaisseur correspondant à la deuxième largeur ; et
le retrait de la matrice (80).

2. Procédé selon la revendication 1, dans lequel le remplissage partiel des nano-pores (82) comprend :
la formation d'une couche d'un premier matériau oxydable (50) ; et
l'anodisation de la couche du premier matériau oxydable (50) pour transférer l'oxyde du premier matériau oxydable (50) vers l'intérieur des nano-pores (82).

3. Procédé selon la revendication 2, dans lequel le remodelage des nano-pores (82) comprend l'attaque acide sélective des nano-pores (82) pour élargir des régions non-remplies des nano-pores (82).

4. Procédé selon la revendication 3, dans lequel le remplissage au moins partiel des sections de nano-pore remodelées (82') comprend l'anodisation supplémentaire du premier matériau oxydable (50) pour transférer l'oxyde vers les sections remodelées (82').

5. Procédé selon la revendication 1, dans lequel la formation d'une matrice comprend :
la formation d'une couche d'un deuxième matériau oxydable (60) ; et
l'anodisation de la couche du deuxième matériau oxydable (60) pour définir les nano-pores (82).

6. Procédé selon la revendication 5, comprenant :
l'anodisation de la couche du deuxième matériau oxydable (60) pour former un oxyde poreux présentant des nano-pores (82) s'étendant à travers l'oxyde poreux pour exposer des parties du premier matériau oxydable (50).

7. Procédé selon la revendication 6, dans lequel l'anodisation du premier matériau oxydable (50) comprend l'anodisation du premier matériau oxydable (50) avec une première tension correspondant à une hauteur cible de portion de tige de nano-pilier (h1).

8. Procédé selon la revendication 6, dans lequel l'anodisation supplémentaire du premier matériau oxydable (50) comprend l'anodisation du premier matériau oxydable (50) avec une deuxième tension correspondant à une hauteur cible de portion de coiffe de nano-pilier (h2).

9. Procédé selon la revendication 6, dans lequel l'élargissement des sections non-remplies des nano-pores (82) comprend l'attaque acide du substrat (20) dans une solution d'attaque conçue pour attaquer l'oxyde poreux avec un degré d'attaque substantiellement supérieur à celui de l'oxyde du premier matériau oxydable (50).
